# EUROPÄISCHE PATENTSCHRIFT

(11) **EP 3 157 072 B1**
(45) Veröffentlichungstag und Bekanntmachung des Hinweises auf die Patenterteilung: **22.03.2023**
(21) Anmeldenummer: 16203223.9
(22) Anmeldetag: 18.06.2008
(51) Int. Cl.: H01L 51/30, H01L 51/54, H01L 51/00, H01L 51/50, C07F 15/00

(54) **VERWENDUNG EINES METALLKOMPLEXES ALS P-DOTAND FÜR EIN ORGANISCHES HALBLEITENDES MATRIXMATERIAL, ORGANISCHES HALBLEITERMATERIAL UND ORGANISCHE LEUCHTDIODE**
USE OF A METAL COMPLEX AS A P-DOPANT FOR AN ORGANIC SEMICONDUCTIVE MATRIX MATERIAL, ORGANIC SEMICONDUCTOR MATERIAL, AND ORGANIC LIGHT-EMITTING DIODE
UTILISATION D'UN COMPLEXE MÉTALLIQUE COMME DOPANT P POUR UN MATÉRIAU DE MATRICE SEMICONDUCTEUR ORGANIQUE, MATÉRIAU DE MATRICE SEMICONDUCTEUR ORGANIQUE ET DIODE ÉLECTROLUMINESCENTES ORGANIQUES

(30) Priorität: 20.06.2007 DE 102007028238
(43) Veröffentlichungstag der Anmeldung: 19.04.2017
(62) Teilanmeldung aus: 08773272.3
(73) Patentinhaber: Novaled GmbH, 01099 Dresden (DE)
(72) Erfinder: Schmid, Günter, 91334 Hemhofen (DE); Krause, Ralf, 91074 Herzogenaurach (DE)
(74) Vertreter: Michalski Hüttermann & Partner Patentanwälte mbB

(56) Entgegenhaltungen:
- EP-A- 1 289 030
- JP-A- 3 208 689
- KRUEGER J ET AL: "MODIFICATION OF TIO2 HETEROJUNCTIONS WITH BENZOIC ACID DERIVATIVES IN HYBRID MOLECULAR SOLID-STATE DEVICES", ADVANCED MATERIALS, WILEY - V C H VERLAG GMBH & CO. KGAA, DE, Bd. 12, Nr. 6, 16. März 2000 (2000-03-16), Seiten 447-451, XP000923878, ISSN: 0935-9648, DOI: 10.1002/(SICI)1521-4095(200003)12:6<447::A ID-ADMA447>3.0.CO;2-8
- F.A. COTTON, E.V. CIKAREV, M.A. PETRUKHINA, S.-E. STIRIBA: POLYHEDRON, Bd. 19, 2000, Seiten 1829-1835, XP002494592,

## Beschreibung

Die Erfindung betrifft die Verwendung eines Metallkomplexes als p-Dotand für ein organisches halbleitendes Matrixmaterial, ein organisches Halbleitermaterial und organische Leuchtdiode.

Die Dotierung organischer halbleitender Materialien mit Elektronenakzeptoren zur Erhöhung der Leitfähigkeit in organischen Matrixmaterialien ist beispielsweise aus der WO 2005/086251 bekannt. Dort werden Metallkomplexe, insbesondere mehrkernige Metallkomplexe wie die so genannten Schaufelradkomplexe (paddle-wheel) wegen ihrer starken Donoreigenschaften als n-Dotanden für die Elektroneninjektion beschrieben. Ferner beschreibt KRUEGER J ET AL: "MODIFICATION OF TIO2 HETEROJUNCTIONS WITH BENZOIC ACID DERIVATIVES IN HYBRID MOLECULAR SOLIDSTATE DEVICES", ADVANCED MATERIALS, WILEY - VCH VERLAG GMBH & CO. KGAA, DE, Bd. 12, Nr. 6, 16. März 2000 (2000-03-16), Seiten 447-451, Solarzellen in denen über einer Schicht aus TiO₂ eine Monolaqe einer Benzoesäure und darüber eine Schicht eines lochleitenden Materials angeordnet sind. Die JP 3 208689 A beschreibt ein Verfahren, um ein optisches Datenaufzeichnungsmedium zu erhalten, das gute Absorptionseigenschaften im Schwingungswellenlängenbereich (750 - 950 nm) eines Halbleiterlasers zeigt, indem eine Aufzeichnungsschicht aus Polythiophen mit einer spezifischen Wiederholungseinheit bereitgestellt wird, die einen spezifischen Nickeldithiolatkomplex als Dotierstoff enthält. Schließlich beschreibt die EP 1 289 030 A eine Vorrichtung mit einem festen konjugierten Halbleiter, umfassend ein Lochtransportmaterial (HTM), wobei das Lochtransportmaterial mit oxidiertem Lochtransportmaterial als Dotierstoff gemischt wird, zu einer Mischung, die als Transportmaterial für dotierte Löcher verwendet werden kann; sowie ein Verfahren zur Herstellung von Vorrichtungen mit einem festen konjugierten Halbleiter.

Es besteht jedoch ein Bedarf, p-Dotanden zur Dotierung der Lochinjektionsschicht zur Verfügung zu stellen.

Aufgabe der vorliegenden Erfindung ist es daher, p-Dotanden für eine lochleitende Matrix anzugeben und die Verwendungen derart dotierter lochleitender Matrixmaterialien in einer strahlungsemittierenden Vorrichtung, insbesondere einer organischen Leuchtdiode (OLED), zu offenbaren.

Diese Aufgabe wird durch die Verwendung eines Metallkomplexes als p-Dotand zur Dotierung eines lochleitenden organischen Matrixmaterials gelöst, wobei der Metallkomplex ein Metallkomplex mit Lewissäureeigenschaft ist und als Elektronenpaarakzeptor wirkt und die Liganden Carbonsäuren oder Carbonsäureanionen mit elektronenziehenden Substituenten sind.

Die Aufgabe wird durch die Merkmale der unabhängigen Ansprüche, insbesondere durch die Verwendung von neutralen Metallkomplexen mit Lewis-Säure Charakter als p-Dotanden in lochleitenden organischen Matrixmaterialien gelöst. Ferner wird die Aufgabe durch die Bereitstellung eines organischen halbleitenden Materials mit einer Verbindung eines solchen Metallkomplexes mit Lewis-Säure Charakter als p-Dotand gelöst. Schließlich wird die Aufgabe noch durch die Angabe von OLEDs mit zumindest einer Schicht eines erfindungsgemäßen organischen Matrixmaterials gelöst.

Gegenstand der Erfindung ist die Verwendung eines neutralen Metallkomplexes mit Lewis-Säure Eigenschaften als p-Dotand eines organischen halbleitenden Matrixmaterials. Weiterhin ist Gegenstand der Erfindung eine Lochleiterschicht, bestehend aus einem lochleitenden organischen Matrixmaterial mit einem Anteil von 0,1 bis 50 (Schichtdicken%) an Metallkomplex als p-Dotanden. Schließlich ist Gegenstand der Erfindung eine OLED, zumindest eine Schicht eines dotierten Lochleitermaterials umfassend, das einen Metallkomplex als p-Dotanden enthält.

Lewis-Säuren sind Verbindungen, die als Elektronenpaarakzeptoren wirken. Eine Lewis-Base ist dementsprechend ein Elektronenpaardonator, der Elektronenpaare abgeben kann. Insbesondere ist die Lewis-Säure-Eigenschaft der Metallkomplexe in Bezug auf das lochleitende organische Matrixmaterial zu setzen, das dann die korrespondierende Lewis-Base darstellt (bzw. enthält).

Ein Metallkompex ist eine Verbindung, in der ein Metallatom bzw. Metallion von einem oder mehreren Liganden koordiniert ist. Im Regelfall ist der Metallkomplex eine metallorganische Verbindung, d.h. ein Komplex, bei dem zumindest ein Teil der Liganden Kohlenstoff-haltig und häufig auch Kohlenwasserstoff-haltig ist.

Vorteilhafterweise handelt es sich bei dem Metallkomplex um einen mehrkernigen Komplex, insbesondere um einen Komplex mit zumindest einer Metall-Metallbindung.

Nach einer vorteilhaften Ausführungsform ist zumindest ein Zentralatom des Metallkomplexes ausgewählt aus der Gruppe der Platinmetalle, folgende Elemente umfassend: Ruthenium, Rhodium, Palladium, Osmium, Iridium und Platin. Insbesondere sind Rhodiumkomplexe bevorzugt.

Nach einer vorteilhaften Ausführungsform ist das Zentralatom ein neutrales oder geladenes, insbesondere positiv geladenes, Übergangsmetallatom.

Unter Lochleitern werden die typische Materialien, die in der OLED lochleitend wirken, wie NPB (N,N'-di-1-napthyl-diphenylbenzidin, HOMO = 5,5 eV; LUMO = 2,4 eV) oder Naphdata (4,4',4"-Tris(N-(1-naphthyl)-N-phenyl -amino)-triphenylamin; HOMO = 5,1 eV; LUMO = 2,3 eV) verstanden.

Die Dotierung wird im Folgenden in relativen Schichtdicken angeben d.h. x % bedeutet, dass die Depositionsrate des Dotanden x % im Bezug auf die Depositionsrate der Matrix beträgt.

Vorteilhafterweise wird als neutraler Metallkomplex ein Komplex mit einer so genannten "paddle-wheel / Schaufelrad" Struktur eingesetzt, wobei besonders bevorzugt zwei- und mehrkernige Metallkomplexe mit zumindest einer Metall-MetallBindung verwendet werden, wie sie beispielsweise aus "Cotton FA, Gruhn NE, Gu J, Huang P, Lichtenberger DL, Murillo Ca, Van Dorn LO und Wilkinson CC: "Closed Shell Molecules That Ionize More Readily Than Cesium" in Science, 2002, 298; 1971-1974 bekannt sind. Ebenfalls beschrieben werden diese Strukturen in der WO 2005/086251. Dort wird jedoch davon ausgegangen, dass mehrkernige Metallkomplexe mit Schaufelradstruktur "paddle-wheel" als n-Dotanden wirken. Dies trifft aber nicht auf alle Paddle-Wheel-Komplexe bzw. die dort genannten Strukturen zu, wie vorliegend gezeigt werden konnte.

In der WO 2005/086251 A2 werden Komplexe mit Schaufelradstruktur als typische n-Dotanden vorgestellt. Um die Verwendbarkeit von Dirhodium-tetratrifluoroacetat (PDW-2), einem typischen Vertreter der Metallkomplexe mit starkem Lewis-Säure Charakter, wie sie vorliegend als p-Dotanden unter Schutz gestellt werden sollen, als n-Dotand zu überprüfen, wurde folgendes Experiment durchgeführt:

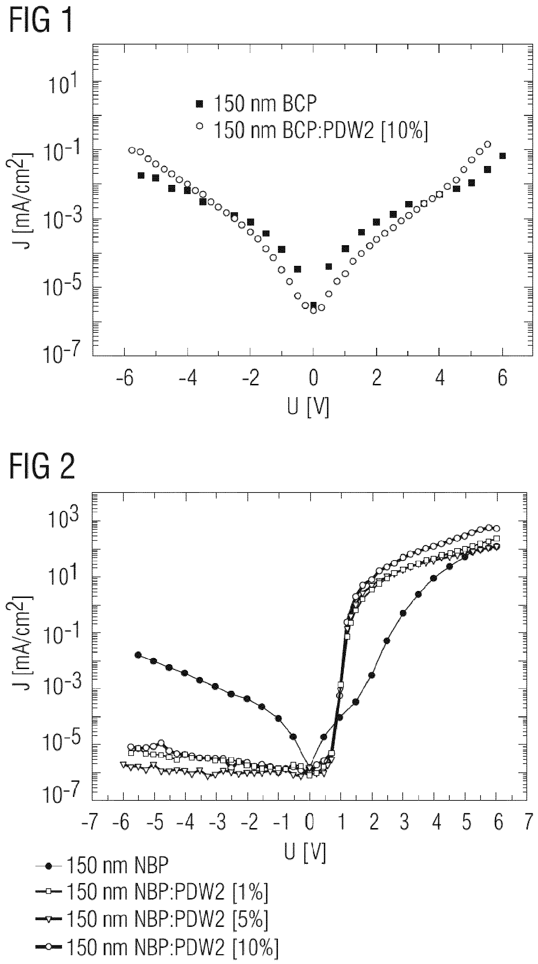

Auf einer ITO (Indium-tin-oxide = indiumdotiertes Zinnoxid) Elektrode wurde durch thermisches Verdampfen eine 150 nm dicke Schicht des Elektronenleiters BCP (= 2,9-Dimethyl-4,7-diphenyl-1,10-phenantholin) abgeschieden. Als Gelegenelektrode diente eine 150 nm dicke Aluminiumschicht. Figur 1 zeigt das Ergebnis, wobei ein 4 mm² großes Bauelement gemessen wurden das die durch Quadrate markierte typische Kennlinie ergab (Figur 1 Quadrate).

In einem zweiten Experiment werden in die BCP-Schicht durch Koverdampfung 10% PDW-2 eindotiert. Die durch Kreise in Figur 1 markierte Kennlinie unterscheidet sich nur unwesentlich von der Kennlinie des reinen BCP. Damit ist PDW-2 generell nicht als n-Dotand einsetzbar, insbesondere nicht in einer OLED und den darin verwendeten typischen Elektronenleitern mit einem typischen HOMO im Bereich 5,8 - 6,2 eV bzw. einem typischen LUMO im Bereich von 3,0 - 2,4 eV.

Analog zum oben beschriebenen Experiment wird PDW-2 durch Koverdampfung in den Lochleiter NPB (= Bis-N,N,N',N'-(naphthyl-phenyl)benzidin) eindotiert. Für eine Dotierung von 0% (Kreise voll), 1%( Quadrate), 5%(Dreiecke) und 10% (Kreise leer) ergaben sich die in Figur 2 dargestellten Kennlinien.

Diese demonstrieren eindeutig die Möglichkeit zur p-Dotierung von lochleitenden Matrixmaterialien durch PDW-2. Erstaunlicherweise können aus Aluminium keine Löcher injiziert werden (negativer Ast der x-Achse), wodurch sich ein Gleichrichtungsfaktor von 3·10⁻⁷ ergibt. Für eine effektive Dotierung reichen nur wenige relative Schichtdicken % aus (insbesondere 0 - 50%, besonders bevorzugt 0 - 15 %). Die Kennlinien zwischen 1 - 10% PDW-2 in NPB sind nahezu identisch. Die Kennlinien sind zudem sehr steil. Bei höheren Spannungen sättigt die Kennlinie, wodurch ein strombegrenzendes Verhalten resultiert.

Die Dotierung organischer Matrixmaterialien mit p-Dotanden ist von entscheidender Relevanz für organische Leuchtdioden. Lumineszenz (cd/m²), Effizienz (cd/A) und Lebensdauer (h) organischer Leuchtdioden hängen stark von der Exzitonendichte in der lichtemittierenden Schicht und der Qualität der Ladungsträgerinjektion ab und werden unter anderem auch durch diese limitiert. Dotierte Transportschichten haben den Vorteil, dass an ihnen relativ zum Gesamtaufbau nur ein Bruchteil der zum Betrieb nötigen Spannung abfällt (<< 30%). Besonders bevorzugt ist die abfallende Spannung sogar um eine Zehnerpotenz oder mehr kleiner, so dass an den Transportschichten kein Spannungsabfall beobachtet wird.

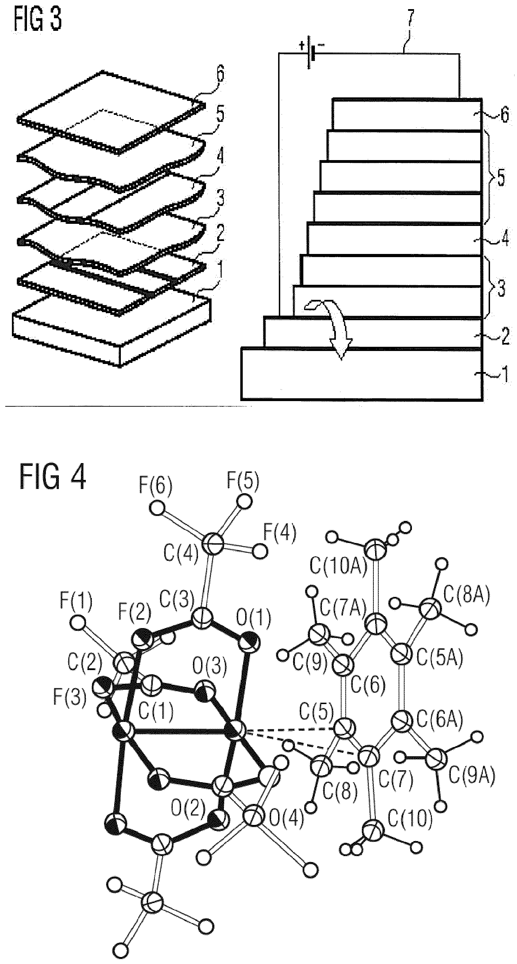

Figur 3 zeigt den Aufbau einer OLED mit einzelnen Funktionsschichten. Zu erkennen ist die unterste und gleichzeitig dickste Schicht 1, die das Substrat, beispielsweise aus Quarz, Glas oder einer Metall- oder Polymerfolie, darstellt. Darauf liegt die transparente Elektrode 2, Z.B. eine Elektrode aus einem transparenten leitenden Oxid. Transparente leitende Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO₂ oder In₂O₃ gehören auch ternäre Metallsauerstoffverbindungen, wie beispielsweise 2n₂SnO₄, CdSnO3, ZnSnO₃, MgIn₂O₄, GaInO₃, ZnzInzOs oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein. Im Fall von Top-emittierenden Dioden kann die Elektrode (2) eine (nicht transparente) Schicht aus Metallen sein. Das Substrat kann dann z.B. eine nicht durchsichtige Metallfolie sein. In Figur 3 ist beispielsweise eine ITO-Anode dargestellt. Auf dieser unteren Elektrode liegt die Lochleiterschicht 3, die gemäß der Erfindung aus einem organischen Matrixmaterial gebildet ist, das mit einem Metallkomplex, der eine Lewissäure darstellt dotiert ist.

Auf der Lochleiterschicht 3 liegt die eigentlich aktive Schicht der OLED, die emittierende Schicht 4. Darauf befindet sich noch die Elektronentransportschicht 5 und die Gegenelektrode 6. Die emittierende Schicht 4 kann z.B. eine organische funktionelle Schicht, z.B. auf der Basis von Polymeren wie Poly(p-phenylen-vinylen) (PPV) oder auf der Basis von so genannten niedermolekularen kleinen Molekülen ("small molecules") wie z.B. Tris(8-hydroxyquinolato)-aluminium (Alq) sein. Weiterhin kann es sich z.B. um phophoreszente Triplettemitter wie Tri(phenylpyridino)Iridium(III), eindotiert in ein Matrixmaterial Bis-N,N'-(carbazoylbiphenyl (CPB), handeln. Die Emitterschicht kann auch aus vielen Einzelemitterschichten bestehen wobei z.B. rotes, grünes oder blaues Licht emittiert wird. Zusätzlich zu den gezeigten Schichten 1 bis 6 ist noch der Schutz der OLED mittels einer Verkapselung zweckmäßig.

Über die elektrische Leitung 7 werden die Elektroden mit der Spannungsquelle verbunden.

Bei großflächigen Leuchtelementen spielt die Homogenität der Ladungsinjektion eine wichtige Rolle. Partikel, Kristallite oder Spitzen verursachen Feldüberhöhungen und damit potentielle Ausgangspunkte für "dark spots" die zum Ausfall des Leuchtelements führen können. Durch eine Lochinjektionsschicht, in die beispielsweise zweikernige Rhodiumacetatbasierte "paddle-wheel"-Komplexe eingebettet sind, kann eine Schicht erzeugt werden, die eine unerwartet hohe Stromtragfähigkeit in Verbindung mit einer inhärenten Strombegrenzung zeigt.

Bevorzugt werden Rhodiumkomplexe eingesetzt, wie Metallkomplex-Verbindungen mit einem Rh₂⁴⁺ Kern und einer Metall-Metallbindung, die aufgrund ihres hohen Lewis-Säure-Charakters als p-Dotand und Elektronenakzeptor wirken.

Besonders bevorzugt ist das Dirhodiumtetratrifluoracetat (Fig. 4), das sich aufgrund seiner günstigen Sublimationseigenschaften sehr gut eignet. In der chemischen Literatur [F. A. Cotton, C. A. Murillo, R. A. Walton "Multiple Bonds between Metal Atoms" 3. Auflage, Springer Science and Business Media, Inc. 2005. 465-611.] konnte unerwarteter Weise auch kristallografisch gezeigt werden, dass sogar unsubstituierte Aromaten als Donor für den Rh₂⁴⁺-Kern in axialer Position dienen können. Experimentell konnte durch die Dotierung von NPB oder Naphdata (Naphdata =4,4',4"-Tris((N-naphthyl)-N-phenyl-amino)-triphenylamin)mit PDW-2 in oben beschriebenen Experimenten gezeigt werden, dass dieser Vorgang eine p-Dotierung bewirkt.

Figur 4 zeigt die Struktur von Rh₂(CF₃COO)₄, an die das aromatische System Hexamethylbenzol koordiniert ist.

Auch die zu Rh₂⁴⁺-Komplexen isoelektronischen Metallkomplexe zu dieser Struktur, insbesondere solche, die noch ähnliche Größen zeigen wie beispielsweise ein Analogon mit Ru₂²⁺-Ionen als Zentralatome sind ebenfalls geeignet als p-Dotanden. Diese bewirken zum einen die Schaufelradstruktur und zum anderen die sehr hohe Lewis-Säure Azidität dieser Komplexe. Insbesondere geeignet sind die als p-Dotanden geeigneten Zentralatome bzw. Metallkomplexe, die direkt an aromatische Systeme, wie z.B. ungeladene aromatische Systeme koordinieren können. Als Zentralatome kommen daher insbesondere die Metalle der 6. bis 9. Nebengruppe in Betracht

Bei einem paddle-wheel-Komplex sind mindestens zwei, zumeist genau zwei Metallzentralatome insbesondere Übergangsmetallatome, durch 1, 2,3 ,4 oder mehr mehrzähnige (insbesondere zweizähnige) Liganden, die an die mindestens zwei Metallzentralatome jeweils ein Ligandenatom binden, überbrückt. Die Metallatome sind hierbei, je nach Radius, zumeist 4-fach mit den genannten Liganden koordiniert.

Der Lewissäurecharakter der paddle-wheel-Komplexe ist insbesondere dadurch gegeben, dass zumindest an einem Metallatom eine lockere oder leere Koordinationsstelle vorhanden ist, an der beispielsweise die Anlagerung eines aromatischen Ringes, wie in Figur 4 gezeigt, stattfinden kann. Die Koordinationsumgebung des Metallatoms ist bevorzugt so, dass eine Metall-MetallBindung besteht sowie 4 äquatoriale Bindungen zu Liganden. Im Regelfall weist daher die axiale Position die lockere oder leere Koordinationsstelle auf, wodurch der Komplex je nach Ligand und Zentralatom Lewis-azid ist.

Als Liganden eignen sich insbesondere alle zwei -oder mehrzähnigen Liganden, bevorzugt elektronenziehende Liganden. Beispielsweise genannt seien die Anionen von elektronenziehenden Carbonsäuren, wie beispielsweise CHalₓH₃₋ₓCOOH, insbesondere CFₓH₃₋ₓCOOH und CClₓH₃₋ₓCOOH (wobei x eine ganze Zahl zwischen 0 und 3 ist und Hal ein Halogenatom darstellt), (CR₁, R₂, R₃) COOH, wobei R₁, R₂ und R₃ unabhängig voneinander Alkyl, wie besonders bevorzugt H, methyl, ethyl, propyl, isopropyl, n- Butyl, sec- Butyl, tert-Butyl, sowie Benzoesäure und deren substituierte Analoga (o, p, m-Fluorbenzoesäure, o,p,m- Cyanobenzoesäure, Nitrobenzoesäure, Alkylbenzoesäuren mit fluorierten oder teilweise fluorierten Alkylgruppen, ggf. auch ein oder mehrfach substituiert, Pyridincarbonsäuren etc.) sein kann.

Die erfindungsgemäß verwendeten Metallkomplexe stellen vorzugsweise Moleküle dar, die unabhängig voneinander verdampfbar sind. Dabei versteht sich, dass einzelne Metallkomplexe jeweils untereinander oder mit anderen Komponenten wie dem Matrixmaterial gebunden sein können.

Rein formal könnten die Valenzelektronen des PDW-2 wie folgt berechnet werden:
In der Gruppe IX mit 4 einfach negativ geladenen zweizähnigen Liganden ergibt sich folgendes Bild für Metall-Metall:
   4 × 4e = 16 Elektronen von den Liganden
   1 × 2e = 2 von der Einfachfachbindung zwischen Rh-Rh
   2 × 9e = 18 vom Rhodium
Summe 36, damit hat jedes Rh Edelgaskonfiguration d.h. stabil Alternativ ergibt sich die Summe 36 für andere Metalle bei gleichen Liganden:
   Metalle der Gruppe 6: Metall - Metall-Vierfachbindung d.h. σ, 2 × π, 1 × δ-Bindung besetzt
   Metalle der Gruppe 7: Metall - Metall-Dreifachbindung d.h. σ, 2 × π, 1 × δ-Bindung, 1 × δ^{∗} besetzt
   Metalle der Gruppe 8: Metall - Metall-Zweifachbindung d.h. σ, 2 × π, 1 × δ-Bindung, 1 × δ^{∗}, 1 × π^{∗} besetzt
   Metalle der Gruppe 9: Metall - Metall-Einfachbindung d.h. σ, 2 × π, 1 × δ-Bindung, 1 × δ^{∗}, 2 × π^{∗} besetzt

Dabei versteht sich, dass einzelne Metallkomplexe jeweils untereinander oder mit anderen Komponenten wie dem Matrixmaterial gebunden sein können. Durch die Bindungsbildung der Donator-Akzeptorwechselwirkung und die Molekülgröße werden die Dopanten in der Matrix fixiert.

Als organische Matrixmaterialien eignen sich alle gängigen Lochleitermatrizen, wie beispielsweise NPB; Naphdata; N,N'-Bis(naphthalen-1-yl)-N,N'-bis(phenyl)-benzidine; N,N'-Bis(naphthalen-2-yl)-N,N'-bis(phenyl)-benzidine; N,N'-Bis(3-methylphenyl)-N,N'-bis(phenyl)-benzidine; N,N'-Bis(3-methylphenyl)-N,N'-bis(phenyl)-9,9-spirobifluorene; N,N'-Bis(naphthalen-1-yl)-N,N'-bis(phenyl)-9,9-spirobifluorene; N,N'-Bis(3-methylphenyl)-N,N'-bis(phenyl)-9,9-dimethyl-fluorene; N,N'-Bis(3-naphthalen-1-yl)-N,N'-bis(phenyl)-9,9-dimethyl-fluorene; N,N'-Bis(3-methylphenyl)-N,N'-bis(phenyl)-9,9-diphenyl-fluorene; N,N'-Bis(3-naphthalen-1-yl)-N,N'-bis(phenyl)-9,9-diphenyl-fluorene; 2,2',7,7'-Tetrakis(N,N-diphenylamino)-9,9'-spirobifluorene; 9,9-Bis[4-(N,N-bis-biphenyl-4-yl-amino)phenyl]-9H-fluorene; 9,9-Bis[4-(N,N-bis-naphthalen-2-yl-amino)phenyl]-9H-fluorene; 9,9-Bis[4-(N,N'-bis-naphthalen-2-yl-N,N'-bis-phenyl-amino)-phenyl]-9H-fluorene; 2,2',7,7'-Tetrakis[(N-naphthalenyl(phenyl)-amino]-9,9-spirobifluorene; N,N'-bis(phenanthren-9-yl)-N,N'-bis(phenyl)-benzidine; 2,7-Bis[N,N-bis(9,9-spiro-bifluorene-2-yl)-amino]-9,9-spirobifluorene; 2,2'-Bis[N,N-bis(biphenyl-4-yl)amino]-9,9-spirobifluorene; 2,2'-Bis(N,N-di-phenyl-amino)-9,9-spirobifluorene; Phthalocyanine-Coppercomplex; 4,4',4"-Tris(N-3-methylphenyl-N-phenyl-amino)triphenylamine; 4,4',4"-Tris(N-(2-naphthyl)-N-phenyl-amino)triphenylamine; 4,4',4"-Tris(N-(1-naphthyl)-N-phenyl-amino)triphenylamine; 4,4',4"-Tris(N,N-diphenyl-amino)triphenylamine; Titanium oxide phthalocyanine; 2,3,5,6-Tetrafluoro-7,7,8,8,-tetracyano-quinodimethane; Pyrazino[2,3-f][1,10]phenanthrolone-2,3-dicarbonitrile; N,N,N',N'-Tetrakis(4-methoxyphenyl)benzidine; 2,7-Bis[N,N-bis(4-methoxy-phenyl)amino]-9,9-spirobifluorene; 2,2'-Bis[N,N-bis(4-methoxy-phenyl)amino]-9,9-spirobifluorene; 1,3-Bis(carbazol-9-yl)benzene; 1,3,5-Tris(carbazol-9-yl)benzene; 4,4',4"-Tris(carbazol-9-yl)triphenylamine; 4,4'-Bis(carbazol-9-yl)biphenyl; 4,4'-Bis(9- carbazolyl)-2,2'-dimethyl-biphenyl; 2,7-Bis(carbazol-9-yl)-9,9-dimentylfluorene und 2,2',7,7'-Tetrakis(carbazol-9-yl)-9,9'-spirobifluorene.

Die experimentell gefundene Strombegrenzung wurde bisher bei keiner der publizierten für die Dotierung geeigneten Materialsysteme beobachtet. Dieser Aspekt ist für großflächige organische Leuchtdioden besonders wichtig, da er eine Homogenisierung der Leuchtdichte bewirkt. Feldüberhöhungen an Partikeln oder Spitzen im Substratmaterial werden durch Schichten mit Strombegrenzung ausgeglichen, da der maximale Stromfluss nicht mehr vom angelegten Feld abhängt.

Im Folgenden wird die Erfindung noch anhand einiger experimenteller Ergebnisse verdeutlicht:

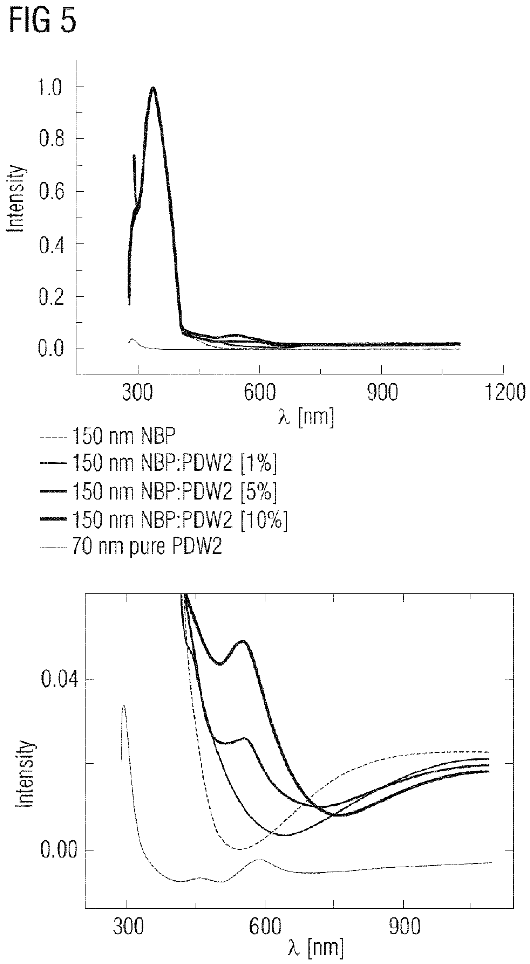

### Beispiel zu Figur 5:

Analog zum oben beschriebenen Experiment wird PDW-2 durch Koverdampfung in den Lochleiter NPB (= Bis-N,N,N',N'-(naphthyl-phenyl)benzidin) eindotiert. Für eine Dotierung von 0%, 1%, 5% und 10% und 100% PDW2 ergeben sich die in Figur 5 dargestellten Kennlinien.

Eine zusätzliche Bande im UV-Spektrum im Bereich zwischen 550-600 nm zeigt die Dotierfähigkeit von NPB durch PDW-2.

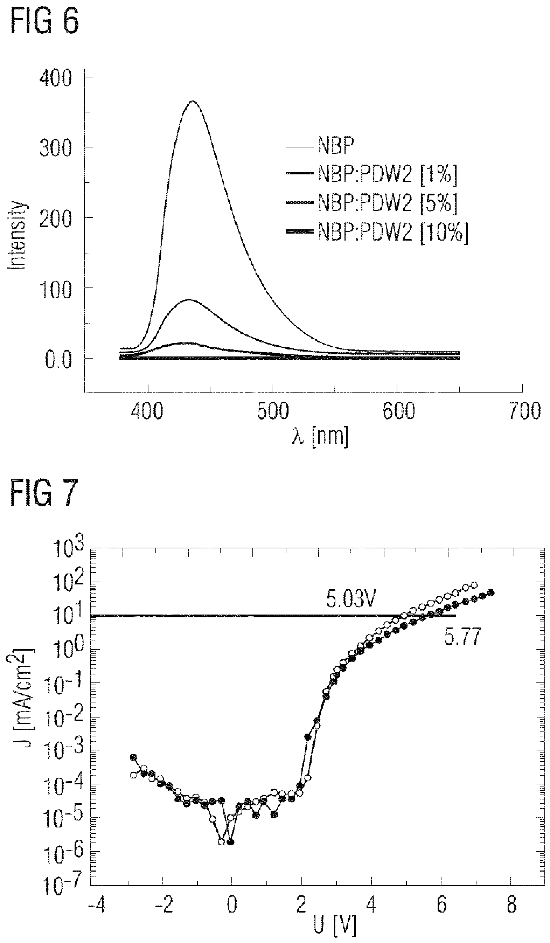

Die Grafik von Figur 6 zeigt das Photolumineszenzspektrum der im oben beschriebenen Beispiel zu Figur 5 dargestellten Schichten. Bei Anregung der Schicht mit UV-Licht von 342 nm nimmt die Fluoreszenz der NPB Schicht stetig ab. Ganz im Einklang zu anderen Dotanten löscht auch PDW-2 die Fluoreszenz.

### Beispiel zu Figur 7:

Auf einer ITO (Indium-tin-oxide = indiumdotiertes Zinnoxid) Elektrode werden nacheinander durch thermisches Verdampfen folgende Schichten abgeschieden, um eine organische Leuchtdiode auf zu bauen (Alq = Aluminiumtrishydroxychinolinat, LiF = Lithiumfluorid).
a. 50 nm NPB; 40 nm NPB; 40 nm Alq; 0.7 nm LiF; 200 nm Al (Kreise voll)
b. 50 nm NPB:PDW-2 [10%]; 40 nm NPB; 40 nm
   Alq; 0.7 nm LiF; 200 nm Al (Kreise leer)

Durch den Einsatz der dotierten Lochinjektionsschicht wird in der I-V-Kennlinie die Spannung von 5.77 V auf 5.03 V reduziert, um eine Stromdichte von 10 mA/cm² zu erreichen. Die Effizienz dieser Diode wird dadurch deutlich verbessert, wie aus Figur 7 ersichtlich ist.

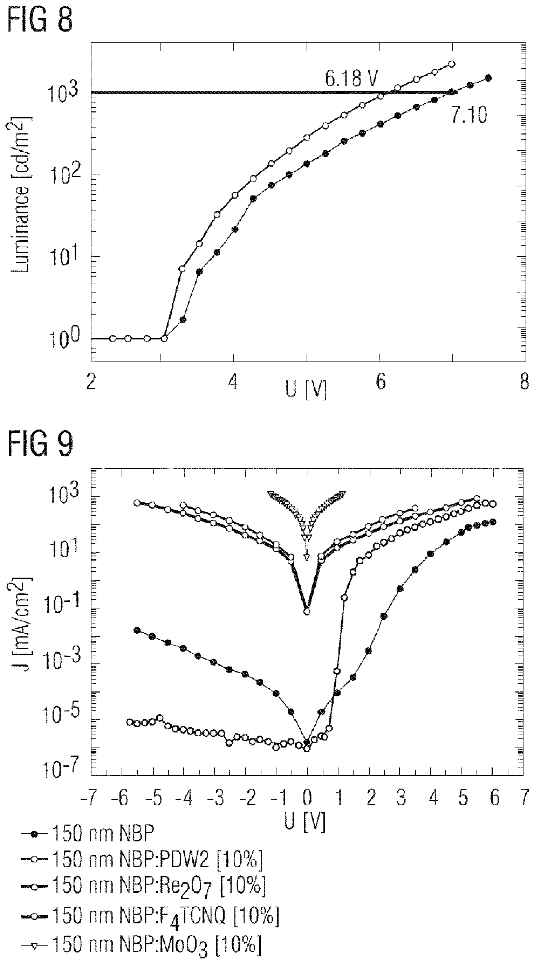

Durch die Reduzierung der Versorgungsspannung wird die Leuchtdichte von 1000 cd/m² schon bei 6.18 V mit der dotierten Lochinjektionsschicht und erst bei 7.10V mit der undotierten Lochinjektionsschicht erreicht (Figur 8).

### Beispiel zu Figur 9:

PDW-2 ist in Aufbauten analog dem Beispiel zu Figur 5 ähnlich effizient, wie andere literaturbekannte Dopanden z.B. MoOs oder F₄TCNQ wie der hier gezeigte Vergleich beweist.

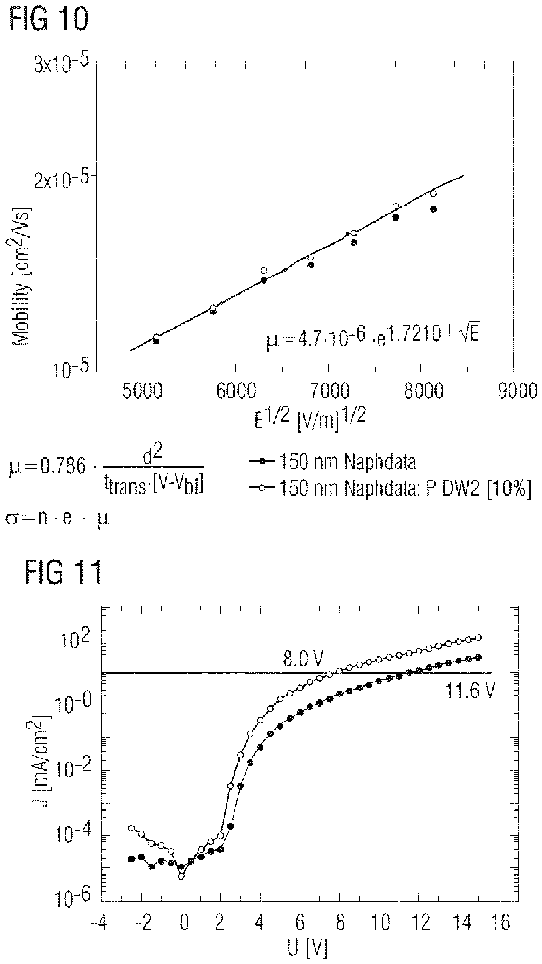

### Beispiel zu Figur 10:

Die Ladungsträgerdichte kann in anderen Lochleitern wie Naphdata durch den Dopanden PDW-2 ebenfalls erhöht werden.

Transiente Dunkelstrommessungen zeigen, dass bei einer Dotierung von 10% PDW-2 in Naphdata die Mobilität nahezu konstant bleibt. Wie das Beispiel zu Fig. 10 demonstriert, steigt die für die organische Leuchtdiode zur Verfügung stehende Ladungsträgerdichte stark an, was sich sehr positiv auf die Kennlinien von organischen Leuchtdioden auswirkt.
(σ = Leitfähigkeit, µ = Mobilität, n = Zahl der Ladungsträger, e = Elementarladung)

### Beispiel zu Figur 11:

Eine analog Beispiel zu Figur 7 aufgebaute Leuchtdiode mit Naphdata statt NPB in der Lochinj ektionsschicht.
a. 50 nm Naphdata; 40 nm NPB; 40 nm Alq; 0.7 nm LiF; 200 nm Al (Kreise voll)
b. 50 nm Naphdata:PDW-2 [10%]; 40 nm NPB; 40 nm Alq; 0.7 nm LiF; 200 nm Al (Kreise leer)

Durch den Einsatz der dotierten Lochinjektionsschicht wird in der I-V-Kennlinie die Spannung von 11.6 V auf 8.0 V reduziert, um eine Stromdichte von 10 mA/cm² zu erreichen. Die Effizienz dieser Diode wird dadurch deutlich verbessert (Figur 11)

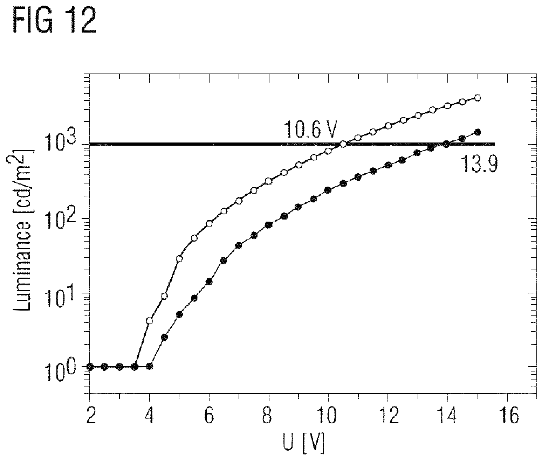

### Beispiel zu Figur 12:

Durch die Reduzierung der Versorgungsspannung wird die Leuchtdichte von 1000 cd/m² schon bei 10.6 V mit der dotierten Lochinjektionsschicht und erst bei 13.9 V mit der undotierten Lochinjektionsschicht erreicht (Figur 12).

Die experimentell gefundene Strombegrenzung wurde bisher bei keiner der publizierten für die Dotierung geeigneten Materialsysteme beobachtet. Dieser Aspekt ist für großflächige organische Leuchtdioden besonders wichtig, da er eine Homogenisierung der Leuchtdichte bewirkt. Feldüberhöhungen an Partikeln oder Spitzen im Substratmaterial werden durch Schichten mit Strombegrenzung ausgeglichen, da der maximale Stromfluss nicht mehr vom angelegten Feld abhängt.

Die Erfindung zeichnet sich insbesondere dadurch aus, dass die verwendeten Materialien OLED kompatibel sind und dass beispielsweise in den bevorzugten zweikernigen Metallkomplexen mit der Metall-Metallbindung formal die Ladung beim Stromtransport im Molekül auf zwei Metallatome verteilt wird, was zur Stabilität der Gesamtschicht beiträgt.

Die Erfindung betrifft die Verwendung eines Metallkomplexes als p-Dotand für ein organisches halbleitendes Matrixmaterial, ein organisches Halbleitermaterial und eine organische Leuchtdiode. Die Erfindung offenbart dabei die Verwendung von Metallkomplexen, die als Lewis-Säuren fungieren als p-Dotanden in organischen Matrixmaterialien.

## Patentansprüche

1. Verwendung eines Metallkomplexes als p-Dotand zur Dotierung eines lochleitenden organischen Matrixmaterials, **dadurch gekennzeichnet, dass** der Metallkomplex ein Metallkomplex mit Lewissäureeigenschaft ist und als Elektronenpaarakzeptor wirkt und die Liganden Carbonsäuren oder Carbonsäureanionen mit elektronenziehenden Substituenten sind.

2. Verwendung nach Anspruch 1, wobei der Metallkomplex ein mehrkerniger Metallkomplex ist.

3. Verwendung nach einem der vorstehenden Ansprüche 1 oder 2, wobei das Zentralatom des Metallkomplexes ein neutrales oder geladenes Übergangsmetallatom ist.

4. Verwendung nach einem der vorstehenden Ansprüche, wobei zumindest ein Zentralatom aus der 6. bis 9. Nebengruppe ausgewählt ist.

5. Verwendung nach dem vorhergehenden Anspruch, wobei zumindest ein Zentralatom Rhodium ist.

6. Verwendung nach einem der vorstehenden Ansprüche, wobei der Metallkomplex ein mehrkerniger Metallkomplex ist, bei dem zumindest ein Ligand zwei Zentralatome koordinativ verbindet.

7. Verwendung nach einem der vorstehenden Ansprüche, wobei zumindest ein Zentralatom quadratisch planar von Liganden umgeben ist.

8. Verwendung nach einem der vorstehenden Ansprüche, wobei der Metallkomplex mehrkernig und symmetrisch aufgebaut ist.

9. Verwendung nach einem der vorstehenden Ansprüche, wobei die Liganden Anionen von elektronenziehenden Carbonsäuren sind und die Carbonsäuren Benzoesäuren oder substituierte Benzoesäuren sind.

10. Verwendung nach einem der vorstehenden Ansprüche, wobei die Liganden Anionen von elektronenziehenden Carbonsäuren sind und die Carbonsäuren Alkylbenzoesäuren mit fluorierten oder teilweise fluorierten Alkylgruppen sind.

11. Verwendung nach einem der vorstehenden Ansprüche 1 bis 9, wobei die Liganden Anionen von elektronenziehenden Carbonsäuren sind und die Carbonsäuren o, p, m-Fluorbenzoesäuren, o,p,m- Cyanobenzoesäuren oder Nitrobenzoesäuren sind.

12. Verwendung nach einem der vorstehenden Ansprüche, wobei der Metallkomplex eine Schaufelradstruktur hat.

13. Halbleitendes Material, insbesondere organisches halbleitendes Material, enthaltend zumindest ein organisches Matrixmaterial und einen p-Dotanden, wobei der p-Dotand ein Metallkomplex mit Lewissäureeigenschaft ist, der als Elektronenpaarakzeptor wirkt und die Liganden des Metallkomplexes Carbonsäuren oder Carbonsäureanionen mit elektronenziehenden Substituenten sind.

14. Halbleitendes Material nach Anspruch 13, wobei das molare Dotierungsverhältnis von p-Dotand zu monomeren Einheiten eines polymeren Matrixmoleküls zwischen 1:1 und 1:100.000 beträgt.

15. Verfahren zur Herstellung eines halbleitenden Materials nach einem der Ansprüche 13 bis 14.

16. Strahlungsemittierende Vorrichtung enthaltend ein halbleitendes Material nach einem der Ansprüche 13 bis 14.

17. Strahlungsemittierende Vorrichtung nach dem vorhergehenden Anspruch, wobei die strahlungsemittiernde Vorrichtung eine organische Leuchtdiode ist, die zwei Elektroden (2), eine Lochleitschicht (3) und eine emittierende Schicht (4) umfasst, wobei die Lochleitschicht (3) das halbleitende Material enthält.

## Claims

1. Use of a metal complex as p-dopant for doping a hole-conducting organic matrix material, **characterized in that** the metal complex is a metal complex having Lewis acid quality and acts as electron pair acceptor and the ligands are carboxylic acids or carboxylic acid anions having electron-withdrawing substituents.

2. Use according to Claim 1, the metal complex being a polynuclear metal complex.

3. Use according to either of preceding Claims 1 and 2, the central atom of the metal complex being a neutral or charged transition metal atom.

4. Use according to any of the preceding claims, at least one central atom being selected from transition groups 6 to 9.

5. Use according to the preceding claim, at least one central atom being rhodium.

6. Use according to any of the preceding claims, the metal complex being a polynuclear metal complex in which at least one ligand coordinatively connects two central atoms.

7. Use according to any of the preceding claims, at least one central atom being surrounded in square-planar configuration by ligands.

8. Use according to any of the preceding claims, the metal complex being polynuclear and symmetrically constructed.

9. Use according to any of the preceding claims, the ligands being anions of electron-withdrawing carboxylic acids and the carboxylic acids being benzoic acids or substituted benzoic acids.

10. Use according to any of the preceding claims, the ligands being anions of electron-withdrawing carboxylic acids and the carboxylic acids being alkylbenzoic acids having fluorinated or partially fluorinated alkyl groups.

11. Use according to any of preceding Claims 1 to 9, the ligands being anions of electron-withdrawing carboxylic acids and the carboxylic acids being o,p,m-fluorobenzoic acids, o,p,m-cyanobenzoic acids or nitrobenzoic acids.

12. Use according to any of the preceding claims, the metal complex having a paddle wheel structure.

13. Semiconducting material, more particularly organic semiconducting material, comprising at least one organic matrix material and a p-dopant, the p-dopant being a metal complex having Lewis acid quality and acting as electron pair acceptor and the ligands of the metal complex being carboxylic acids or carboxylic acid anions having electron-withdrawing substituents.

14. Semiconducting material according to Claim 13, the molar doping ratio of p-dopant to monomer units of a polymeric matrix molecule being between 1:1 and 1:100 000.

15. Method for producing a semiconducting material according to either of Claims 13 and 14.

16. Radiation-emitting device comprising a semiconducting material according to either of Claims 13 and 14.

17. Radiation-emitting device according to the preceding claim, the radiation-emitting device being an organic light-emitting diode which comprises two electrodes (2), a hole-conducting layer (3) and an emitting layer (4), the hole-conducting layer (3) comprising the semiconducting material.

## Revendications

1. Utilisation d'un complexe métallique comme dopant p pour doper un matériau matrice organique conducteur de trous, **caractérisée en ce que** le complexe métallique est un complexe métallique ayant des propriétés d'acide de Lewis et fonctionnant comme accepteur de paires d'électrons, les ligands étant des acides carboxyliques ou des anions d'acides carboxyliques comportant des substituants attracteurs d'électrons.

2. Utilisation selon la revendication 1, dans laquelle le complexe métallique est un complexe métallique polynucléaire.

3. Utilisation selon l'une des revendications 1 ou 2, dans laquelle l'atome central du complexe métallique est un atome de métal de transition neutre ou chargé.

4. Utilisation selon l'une des revendications précédentes, dans laquelle au moins un atome central est choisi parmi les groupes secondaires 6 à 9.

5. Utilisation selon la revendication précédente, dans laquelle au moins un atome central est du rhodium.

6. Utilisation selon l'une des revendications précédentes, dans laquelle le complexe métallique est un complexe métallique polynucléaire, dans lequel au moins un ligand relie deux atomes centraux par liaison de coordination.

7. Utilisation selon l'une des revendications précédentes, dans laquelle au moins un atome central est entouré de ligands avec une géométrie plane quadratique.

8. Utilisation selon l'une des revendications précédentes, dans laquelle le complexe métallique est polynucléaire et a une structure symétrique.

9. Utilisation selon l'une des revendications précédentes, dans laquelle les ligands sont des anions d'acides carboxyliques attracteurs d'électrons et les acides carboxyliques sont des acides benzoïques ou des acides benzoïques substitués.

10. Utilisation selon l'une des revendications précédentes, dans laquelle les ligands sont des anions d'acides carboxyliques attracteurs d'électrons et les acides carboxyliques sont des acides alkylbenzoïques comportant des groupes alkyle fluorés ou partiellement fluorés.

11. Utilisation selon l'une des revendications précédentes 1 à 9, dans laquelle les ligands sont des anions d'acides carboxyliques attracteurs d'électrons et les acides carboxyliques sont des acides o, p, m-fluorobenzoïques, des acides o, p, m-cyanobenzoïques ou des acides nitrobenzoïques.

12. Utilisation selon l'une des revendications précédentes, dans laquelle le complexe métallique a une structure en roue à aubes.

13. Matériau semiconducteur, en particulier matériau organique semiconducteur, contenant au moins un matériau matrice organique et un dopant p, le dopant p étant un complexe métallique ayant des propriétés d'acide de Lewis, qui fonctionne comme accepteur de paires d'électrons, et les ligands du complexe métallique étant des acides carboxyliques ou des anions d'acides carboxyliques comportant des substituants attracteurs d'électrons.

14. Matériau semiconducteur selon la revendication 13, le rapport molaire de dopage du dopant p aux motifs monomères d'une molécule matrice polymère étant compris entre 1:1 et 1:100 000.

15. Procédé de fabrication d'un matériau conducteur selon l'une des revendications 13 à 14.

16. Dispositif électroluminescent contenant un matériau semiconducteur selon l'une des revendications 13 à 14.

17. Dispositif luminescent selon la revendication précédente, le dispositif luminescent étant une diode électroluminescente organique qui comprend deux électrodes (2), une couche conductrice de trous (3) et une couche émettrice (4), la couche conductrice de trous (3) contenant le matériau semiconducteur.
